(19) Europäisches Patentamt / European Patent Office / Office européen des brevets

(11) **EP 1 763 891 B1**

(12) **FASCICULE DE BREVET EUROPEEN**

(45) Date de publication et mention de la délivrance du brevet:
**03.10.2012 Bulletin 2012/40**

(21) Numéro de dépôt: **05777141.2**

(22) Date de dépôt: **14.06.2005**

(51) Int Cl.:
*H01J 37/32* *(2006.01)*

(86) Numéro de dépôt international:
**PCT/FR2005/001466**

(87) Numéro de publication internationale:
**WO 2006/003321 (12.01.2006 Gazette 2006/02)**

(54) **ALIMENTATION D'IMPLANTEUR IONIQUE PREVUE POUR UNE LIMITATION DE L'EFFET DE CHARGE**

IONENIMPLANTATIONVERSORGUNG ZUR LADUNGEFFEKTBEGRENZUNG

ION IMPLANTER POWER SUPPLY WHICH IS INTENDED TO LIMIT THE LOADING EFFECT

(84) Etats contractants désignés:
**AT BE BG CH CY CZ DE DK EE ES FI FR GB GR HU IE IS IT LI LT LU MC NL PL PT RO SE SI SK TR**

(30) Priorité: **16.06.2004 FR 0406495**

(43) Date de publication de la demande:
**21.03.2007 Bulletin 2007/12**

(73) Titulaire: **Ion Beam Services**
**13790 Peynier (FR)**

(72) Inventeurs:
• **TORREGROSA Frank**
**F-13109 Simiane (FR)**
• **MATHIEU Gilles**
**F-13007 Marseille (FR)**

(74) Mandataire: **Renaud-Goud, Thierry**
**Renaud-Goud Conseil**
**5, rue de Montigny**
**13100 Aix-en-Provence (FR)**

(56) Documents cités:
**US-A- 5 558 718**

• YUKIMURA K ET AL: "Two switch high voltage modulator for plasma-based ion implantation" SURFACE & COATINGS TECHNOLOGY ELSEVIER SWITZERLAND, vol. 156, no. 1-3, 1 juillet 2002 (2002-07-01), pages 66-70, XP002314548 ISSN: 0257-8972
• BOEHM G ET AL: "50-KV PULSE GENERATOR FOR PALSMA SOURCE ION IMPLANTATION" JOURNAL OF VACUUM SCIENCE AND TECHNOLOGY: PART B, AMERICAN INSTITUTE OF PHYSICS. NEW YORK, US, vol. 12, no. 2, 1 mars 1994 (1994-03-01), pages 821-822, XP000442755 ISSN: 1071-1023

**Description**

La présente invention concerne une alimentation d'implanteur ionique prévue pour limiter l'effet de charge.

Le domaine de l'invention est celui des implanteurs ioniques opérant en mode immersion plasma. Ainsi, l'implantation ionique d'un substrat consiste à l'immerger dans un plasma et à le polariser en tension négative, de quelques dizaines de Volts à quelques dizaines de kilovolts (généralement moins de 100 kV), ceci de façon à créer un champ électrique capable d'accélérer les ions du plasma vers le substrat.

La profondeur de pénétration des ions est déterminée par leur énergie d'accélération. Elle dépend d'une part de la tension appliquée au substrat et d'autre part de la nature respective des ions et du substrat. La concentration d'atomes implantés dépend de la dose qui s'exprime en nombre d'ions par $cm^2$ et de la profondeur d'implantation.

Pour des raisons liées à la physique des plasmas, il se crée, en quelques nanosecondes après l'application de la tension, une gaine ionique autour du substrat. La différence de potentiel responsable de l'accélération des ions vers le substrat se retrouve aux bornes de cette gaine.

La croissance de cette gaine en fonction du temps suit l'équation de Child-Langmuir :

$$ j_c = \frac{4}{9} \, \varepsilon_0 \left( \frac{2e}{M} \right)^{1/2} \frac{V_0^{3/2}}{s^2} $$

où:

$j_c$ : densité de courant,
$\varepsilon_0$ : permitivité du vide,
e : charge de l'ion,
M : masse de l'ion,
$V_0$ : différence de potentiel au travers de la gaine, et
s : épaisseur de la gaine.

En stipulant que la densité de courant est égale à la charge traversant la limite de la gaine par unité de temps, ds/dt représente la vitesse de déplacement de cette limite :

$$ \frac{ds}{dt} = \frac{2}{9} \frac{s_0^2 \cdot u_0}{s^2} $$

Expression dans laquelle $s_0$ vaut :

$$ s_0 = \left( \frac{2\varepsilon_0 V_0}{e.n_0} \right)^{1/2} $$

étant entendu que $u_0 = (2eV_0 / M)$ est la vitesse caractéristique de l'ion et que $n_0$ est la densité du plasma.

L'épaisseur de la gaine est liée principalement à la tension appliquée, à la densité du plasma et à la masse des ions.

L'impédance équivalente du plasma qui conditionne le courant d'implantation est directement proportionnelle au carré de l'épaisseur de gaine. Le courant d'implantation décroît donc très rapidement lorsque la gaine augmente.

Au bout d'un certain laps de temps, il est nécessaire de procéder à une réinitialisation. Ceci s'avère pratiquement indispensable lorsque la gaine atteint les parois de l'enceinte stoppant ainsi le mécanisme d'implantation.

Afin de réinitialiser le système, la quasi-totalité des fabricants d'implanteurs arrête la haute tension sur le substrat tout en maintenant le plasma allumé. Il faut donc disposer d'un générateur pulsé qui produit des impulsions de haute tension.

Par ailleurs, l'implantation nécessite une énergie d'accélération la plus stable possible et, par conséquent, il convient de satisfaire aux spécifications suivantes :

- temps de montée et de descente inférieurs à 1 µs,
- stabilité de la haute tension lors de l'impulsion,
- courant instantané très important, de 1 à 300 A,
- capacité à supporter des arcs dans le plasma.

L'implantation ionique en mode immersion plasma présente un certain nombre d'inconvénients.

Tout d'abord, les alimentations haute tension pulsées sont très coûteuses, souvent fragiles et conditionnent directement la qualité de l'implantation réalisée.

Ensuite, la présence continue du plasma dans l'enceinte donne lieu à des effets secondaires indésirables :

- génération de particules,
- apport thermique au substrat,
- agression de l'enceinte en générant des risques de contamination métallique des pièces traitées, et
- création d'effets de charge, particulièrement gênants dans le cas des applications microélectroniques.

Afin de réduire ces effets secondaires, la société VARIAN a proposé un procédé à plasma pulsé dit « PLAD » (pour le vocable anglais PLAsma Doping). Ce procédé est présenté dans deux articles de la revue Surface and Coatings Technology n° 156 (2002) « Proceedings of the VIth International Workshop on Plasma-Based Ion Implantation (PBII - 2001), Grenoble, France, 25-28 June, 2001 » publiée par Elsevier Science B.V. :

- S.B. Felch et al. : "Plasma doping for the fabrication of ultra shallow junctions", pages 229-236 ;
- D. Lenoble et al. : "The fabrication of advanced transistors with plasma doping", pages 262-266.

Ce procédé consiste lui aussi à polariser le substrat avec une haute tension pulsée. Toutefois, le champ électrique créé entre le substrat et une électrode à la masse située en vis-à-vis permet de pulser le plasma. Les lignes de champ autour du substrat permettent l'accélération et l'implantation des ions. Dans ce procédé, le plasma pulsé permet de s'affranchir d'une partie des effets secondaires précédemment décrits mais les contraintes liés à l'usage d'un générateur d'impulsions haute tension sont toujours présentes. De plus, les caractéristiques du plasma ne peuvent être disjointes de la tension de polarisation. De ce fait, la machine est très peu versatile : elle présente une gamme de tension d'accélération réduite et il est toujours difficile d'implanter des espèces peu plasmagènes.

D'un autre côté, le document US 5 558 718 enseigne un appareil et une méthode d'implantation ionique à plasma pulsé. Cet appareil d'implantation ionique est dépourvu de générateur d'impulsions haute tension. Il fait appel à une source de plasma pulsée et à un générateur de puissance qui délivre une tension constante pour polariser la cible.

Dans le cas de mise en oeuvre de grandes cibles nécessitant des courants importants, une branche de dérivation pourvue d'un condensateur à forte capacité et d'une résistance en série est monté en parallèle avec ce générateur de puissance car il importe que la tension appliquée à la cible soit la plus stable possible durant la phase d'implantation.

En premier lieu, le flux important d'ions créé par l'implantation cause une accumulation de charges positives sur les zones isolantes du substrat (oxydes de surface, dépôts isolants en surface, polymères déposés tels que résines de photolithographie, ...), phénomène qui se présente avec une acuité particulière dans le domaine de la microélectronique. Cette accumulation de charges entraîne une augmentation non maîtrisée du potentiel en ces zones isolantes. Lorsque la différence de potentiel entre une telle zone isolante et une zone conductrice du substrat atteint un seuil critique, il y a création d'un arc électrique qui cause une destruction locale du substrat.

Le problème lié à cette accumulation de charges pour les implanteurs classiques dits « à fort courant » a trouvé une solution lorsque les substrats sont localisés dans des endroits exempts de fort champ électrique. Dans ce cas, on peut utiliser des canons à électrons pour neutraliser la charge positive causée par le flux d'ions implantés. Toutefois, cette solution n'est pas applicable si le substrat est polarisé au moyen d'une haute tension négative. De plus, un canon à électrons serait une source de contamination métallique.

L'invention a ainsi pour premier objet de limiter l'effet de charge dans un implanteur fonctionnant en mode plasma pulsé.

Selon ce premier objet, une alimentation d'implanteur ionique comprend un générateur électrique continu disposé entre un plateau porte-substrat et la masse, et comprend aussi un condensateur dans une branche de dérivation également disposée entre le plateau porte-substrat et la masse ; de plus, ce condensateur a une capacité inférieure à 5 nF.

L'alimentation est ainsi réalisée de façon à limiter l'effet de charge. En effet, le condensateur CDS présente une capacité de faible valeur si bien que la tension à ses bornes tend progressivement vers zéro lors de sa décharge.

En second lieu, ce générateur de puissance consomme beaucoup d'énergie. Il doit être conçu de façon à être adapté au volume de la cible à ioniser et la constante de temps de la branche de dérivation doit être supérieure à la durée de l'impulsion issue de la source plasma.

L'invention a ainsi pour second objet d'apporter une amélioration à cette situation.

Selon ce deuxième objet, la branche de dérivation se réduit au condensateur.

On supprime la résistance qui est la cause des contraintes mentionnées ci-dessus.

Suivant un premier mode de réalisation, le générateur étant un générateur de tension, l'alimentation comporte une impédance de charge en série avec celui-ci.

De préférence, cette impédance de charge est une résistance qui est comprise entre 200 et 2 000 kΩ.

Avantageusement, la tension délivrée par ce générateur est comprise entre - 100 et - 10 000 Volts.

Suivant un deuxième mode de réalisation de l'alimentation, le générateur est un générateur de courant.

Avantageusement, la tension délivrée par ce générateur est alors comprise entre - 100 et - 100 000 Volts.

L'invention s'applique préférentiellement à un implanteur ionique qui comporte une alimentation telle que spécifiée ci-dessus et une source plasma pulsée, cet implanteur comprenant des moyens pour que la durée de l'impulsion plasma émise par cette source plasma pulsée soit comprise entre 20 et 5 000 μs.

Lorsque le générateur de l'alimentation est un générateur de courant, il est souhaitable que l'implanteur comprenne des moyens pour inhiber ce générateur durant une impulsion plasma.

Quel que soit le type de générateur adopté, selon une caractéristique additionnelle, l'impédance électrique du plasma $Z_p$ est comprise entre 30 et 300 kΩ et la pression de travail est inférieure à $5.10^{-3}$ mbar.

Par ailleurs, la capacité C du condensateur, la durée $t_p$ de l'impulsion produite par la source plasma pulsée, l'impédance du plasma, la tension d'inversion $V_{inv}$ et la tension $V_{ali}$ délivrée par le générateur sont régis par la formule :

$$C / t_p < -1 / (Z_p \cdot \ln (V_{inv} / V_{ali})).$$

De préférence, le plateau porte-substrat est mobile en rotation autour de son axe.

En outre, le plateau porte-substrat et la source plasma pulsée présentent un désaxage réglable.

La présente invention apparaîtra maintenant avec plus de détails dans le cadre de la description qui suit d'un exemple de réalisation donné à titre illustratif en se référant au dessin joint au sein duquel :

- la figure 1 représente un implanteur en coupe schématique verticale,
- la figure 2 représente une première variante d'alimentation du plateau porte-substrat, et
- la figure 3 représente une seconde variante d'alimentation de ce plateau.

Les éléments présents sur plusieurs figures sont affectés d'une seule et même référence.

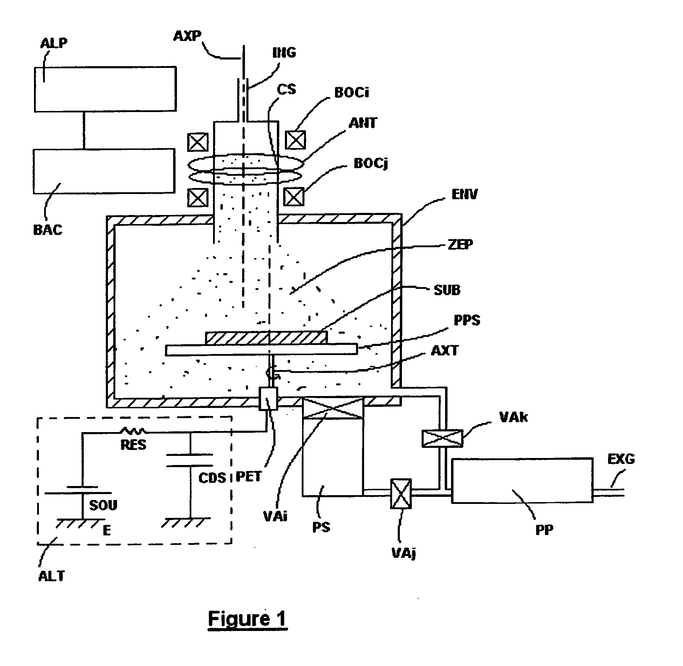

Tel que montré sur la figure 1, un implanteur ionique comporte plusieurs éléments agencés à l'intérieur et à l'extérieur d'une enceinte à vide ENV. Pour les applications microélectroniques, il est préconisé d'utiliser une enceinte en alliage d'aluminium si l'on souhaite limiter la contamination en éléments métalliques tels que Fer, Chrome, Nickel ou Cobalt. Un revêtement en silicium ou en carbure de Silicium peut aussi être utilisé.

Un plateau porte substrat PPS, se présentant sous la forme d'un disque à plan horizontal, mobile autour de son axe vertical AXT, reçoit le substrat SUB devant subir l'implantation ionique.

Un passage électrique haute tension PET ménagé dans la partie inférieure de l'enceinte ENV relie électriquement l'axe vertical du plateau AXT, et donc le plateau porte-substrat PPS, à une alimentation ALT.

Classiquement, cette alimentation porte-substrat ALT comporte un générateur de tension continue SOU dont le pôle positif est raccordé à la masse. Une branche de dérivation qui est montée en parallèle sur ce générateur est formée d'un condensateur CDS et d'une résistance RES en série.

Des moyens de pompage PP, PS sont également disposés à la partie inférieure de l'enceinte ENV. Une pompe primaire PP est reliée en entrée à l'enceinte ENV par une conduite munie d'une vanne VAk, et en sortie à l'air libre par une conduite d'échappement EXG. Une pompe secondaire PS est reliée en entrée à l'enceinte ENV par une conduite munie d'une vanne VAi, et en sortie à l'entrée de la pompe primaire PP par une conduite munie d'une vanne VAj. Les conduites ne sont pas référencées.

La partie supérieure de l'enceinte ENV reçoit le corps de source CS, cylindrique, d'axe vertical AXP. Ce corps est en quartz. Il est extérieurement entouré, d'une part par des bobines de confinement BOCi, BOCj, et d'autre part par une antenne radiofréquence ANT extérieure. Cette antenne est reliée électriquement, via une boite d'accord BAC, à une source radiofréquence pulsée ALP. L'entrée de gaz plasmagène ING est coaxiale à l'axe vertical AXP du corps de source CS. Cet axe vertical AXP rencontre la surface du plateau porte substrat PPS sur lequel est disposé le substrat à implanter SUB.

Il est possible d'utiliser tout type de source plasma pulsée : décharge, ICP (pour « Inductively Coupled Plasma » en anglais), Helicon, micro-ondes, arc. Ces sources doivent travailler à des niveaux de pression suffisamment faibles pour que le champ électrique créé entre le plateau PPS à haute tension et l'enceinte ENV à la masse n'allume pas un plasma de décharge qui vienne perturber le fonctionnement pulsé de la source.

Le choix de la source doit permettre d'avoir un potentiel plasma proche de zéro. En effet, l'énergie d'accélération des ions est la différence entre le potentiel plasma et le potentiel du substrat. L'énergie d'accélération est alors contrôlée uniquement par la tension appliquée au substrat. Ce point devient prédominant si l'on souhaite des énergies d'accélération très faibles, inférieures à 500 eV, ce qui est le cas pour des applications en microélectronique.

Pour des applications nécessitant un faible niveau de contamination métallique, telles la microélectronique encore une fois et le traitement de pièces dans le domaine médical, la source ne doit pas présenter d'élément métallique contaminant en contact avec le plasma. Dans le mode de réalisation présenté, une source RF formée d'un tube en quartz est associée à une antenne radiofréquence extérieure ANT et à des bobines de confinement magnétique BOCi, BOCj comme précisé précédemment.

N'importe quelle espèce plasmagène peut être implantée. Il est possible de partir d'un précurseur gazeux tel $N_2$, $O_2$, $H_2$, He, Ar, $BF_3$, $B_2H_6$, $AsH_3$, $PH_3$, $SiH_4$, $C_2H_4$, d'un précurseur liquide tel $TiCl_4$, $H_2O$, ou d'un précurseur solide. Dans ce dernier cas, il convient d'utiliser un système d'évaporation thermique (phosphore) ou un système arc (« hollow cathode » en anglais).

Le procédé d'implantation mettant en oeuvre l'implanteur comporte de manière périodique la répétition des quatre ou cinq phases suivantes :

- une phase de charge du condensarteur CDS (la source plasma ALP étant éteinte) par le générateur SOU jusqu'à l'obtention d'une tension de décharge,
- une phase d'allumage du plasma qui est initiée lorsque la tension du substrat atteint la tension de décharge : l'impédance du plasma n'étant plus infinie, le condensateur CDS se décharge à travers celui-ci,
- une phase de décharge du condensateur CDS, durant laquelle l'implantation est réalisée et pendant laquelle la gaine s'étend, et
- une phase d'extinction du plasma qui est initiée lorsque la phase précédente a duré le temps souhaité : l'impédance du plasma est à nouveau infinie et la phase de charge peut être réitérée,
- une éventuelle phase d'attente, durant la quelle rien ne se passe, qui permet d'ajuster la période de répétition.

Lors de la phase de décharge qui dure le temps d'une impulsion plasma, une zone d'extension plasma ZEP constituée d'un nuage de gaz ionisé se forme entre le corps de source CS et le plateau porte substrat PPS. Les particules viennent heurter le substrat à implanter SUB avec une énergie permettant leur pénétration à l'intérieur du substrat SUB.

L'alimentation porte-substrat ALT est réalisée selon l'invention de façon à limiter l'effet de charge. Pour ce faire, le condensateur CDS présente une capacité de faible valeur afin de faire revenir progressivement le potentiel du substrat à une valeur voisine de zéro lors de sa phase de décharge.

En effet, même si l'utilisation d'un plasma pulsé permet la limitation de l'effet de charge, ce problème demeure surtout si le potentiel du substrat reste très négatif pendant le procédé (cas de l'utilisation d'un condensateur de forte capacité).

Dans le cas de l'utilisation d'un condensateur de faible capacité et d'une impulsion plasma suffisamment longue, il se produit le phénomène suivant :

- au début de l'impulsion, le condensateur est chargé, le potentiel du substrat est fixé par la tension de charge et les ions sont accélérés vers le substrat selon le mécanisme décrit précédemment ;
- la tension aux bornes du condensateur chute car celui-ci se décharge dans le plasma ;
- au-dessus d'un certain potentiel, que nous nommerons potentiel d'inversion, les charges positives accumulées sur les zones isolantes génèrent un champ électrique alors prédominant qui attire les électrons du plasma ; il y a alors neutralisation de ces charges positives et suppression des risques d'arcage.

Cette neutralisation est d'autant plus efficace que la pression de travail est faible. En effet, si le libre parcours moyen des électrons est important, le flux d'électrons qui atteint la surface pour neutraliser l'effet de charge est lui aussi conséquent.

Les conditions nécessaires à l'établissement de ce mécanisme sont donc :

- capacité du condensateur CDS suffisamment faible,
- durée de l'impulsion plasma suffisamment longue pour atteindre le potentiel d'inversion avant que les charges accumulées en surface ne causent des arcages, et
- pression de travail suffisamment faible pour que le libre parcours moyen des électrons créés par la source plasma leurs permettent d'atteindre le substrat sans risque de collision et de recombinaison avec les molécules de gaz et les ions présents dans l'enceinte.

A titre d'exemple, les paramètres suivants peuvent être adoptés :

- condensateur CDS de capacité C comprise entre 300 pF et 5 nF ;
- durée tp de l'impulsion plasma comprise entre 20 $\mu$s et 5 000 $\mu$s, préférentiellement entre 20 $\mu$s et 500 $\mu$s ;
- tension d'inversion $V_{INV}$ du flux d'ions généré dans l'implanteur comprise entre - 20 et - 200 Volts (cette tension d'inversion dépend des charges positives stockées sur les zones isolantes du substrat) ;
- impédance électrique Zp du plasma généré dans l'implanteur comprise entre 30 et 300 k$\Omega$ (cette impédance dépend du réglage de la source plasma) ;
- tension délivrée par le générateur $V_{ali}$ comprise entre - 100 et - 10 000 Volts, préférentiellement entre - 100 et - 5 000 Volts ;
- pression de travail au sein de l'implanteur inférieure à $5.10^{-3}$ mbar, préférentiellement à $2.10^{-3}$ mbar ;
- fréquence de répétition des impulsions plasma comprise entre 1 et 500 Hz.

La valeur de la tension d'inversion $V_{INV}$ correspond à la valeur du potentiel à atteindre lors de la décharge du condensateur CDS pour observer la suppression des arcages.

La valeur Zp de l'impédance équivalente du plasma dépend de la densité du plasma qui dépend elle-même de la pression.

On se place dans le cas où le courant de recharge du condensateur CDS pendant l'impulsion plasma est négligeable, c'est-à-dire si la résistance de charge Z en série avec le générateur de tension SOU présente une valeur très élevée.

Il faut qu'au cours d'une impulsion plasma, la tension de polarisation $V_{pla}$ revienne à une valeur supérieure à la tension $V_{INV}$ d'inversion de flux ions/électrons :

$$V_{pla} > V_{inv}$$

Sachant que:

$$V_{pla} = V_{ali}\ e^{-tp\,/\,Zp.C}$$

Il s'ensuit une relation entre la durée minimale de l'impulsion plasma tp et la valeur maximale de capacité C (en notant ln le logarithme népérien) :

$$C\,/\,tp < -\,1\,/\,(Zp.\ \ln\,(V_{inv}\,/\,V_{ali})).$$

Il convient donc de rechercher une longue durée tp d'impulsions plasma et/ou une capacité C de faible valeur.

En retenant les valeurs suivantes :

- tension d'inversion $V_{INV}$ du flux d'ions de - 60 Volts,
- tension délivrée par le générateur de tension SOU de -1 000 Volts,
- impédance électrique Zp du plasma de 100 k$\Omega$,
- durée tp de l'impulsion plasma de 100 $\mu$s,

alors, la capacité C ne doit pas excéder 350 pF.

L'invention a également pour objet d'améliorer encore les performances de l'alimentation porte-substrat ALT.

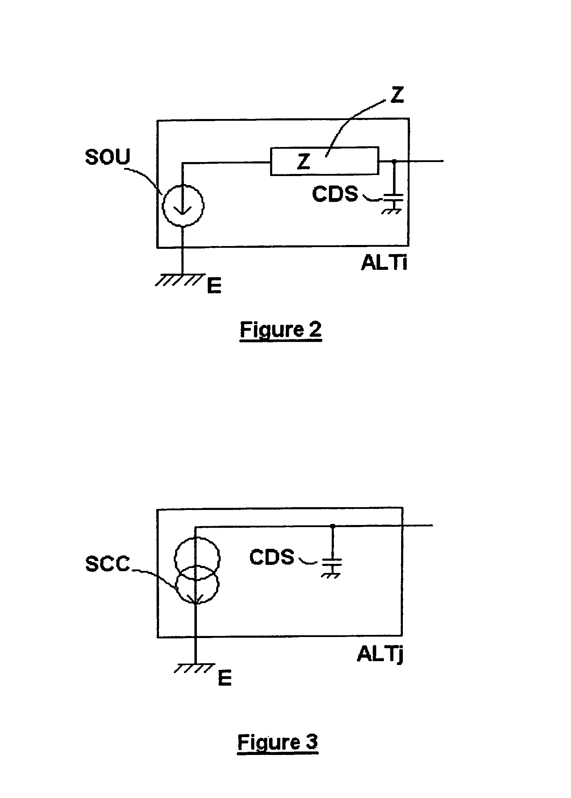

En référence à la figure 2, selon un premier mode de réalisation, l'alimentation du porte-substrat se présente maintenant comme une alimentation plateau ALTi qui comporte une impédance de charge Z dont le premier pôle est relié au pôle négatif du générateur de tension continue SOU. Le deuxième pôle de cette impédance de charge est raccordé au plateau porte-substrat PPS et au premier pôle du condensateur CDS dont le deuxième pôle est relié à la masse.

Cette impédance de charge Z qui est souvent une résistance a pour fonction de limiter le courant au début de la charge du condensateur CDS. De plus, si cette résistance est supérieure à l'impédance équivalente du plasma, elle permet également de limiter la recharge de ce condensateur pendant l'impulsion plasma où l'on désire la décharger.

Pour une impédance plasma typiquement égale à 100 k$\Omega$, la résistance de charge sera préférentiellement comprise entre 200 k$\Omega$ et 2 000 k$\Omega$. La capacité du condensateur CDS est telle que sa décharge est pratiquement complète à la fin d'une impulsion plasma.

Les paramètres couramment utilisés dans ce mode sont :

- densité plasma comprise entre $10^8$ et $10^{10}$/cm$^3$,
- durée d'impulsion plasma comprise entre 15 μs et 500 μs,
- fréquence de répétition des impulsions comprise entre 1 Hz et 3 kHz,
- pression de travail comprise entre $2.10^{-4}$ et $5.10^{-3}$ mbar,
- gaz employé : N$_2$ BF$_3$, O$_2$, H$_2$, PH$_3$, AsH$_3$, ou Ar,
- impédance de charge Z qui est une résistance supérieure à 300 kΩ,
- capacité C de 500 pF,
- tension de polarisation comprise entre - 100 et - 10 000 Volts.

En référence à la figure 3, selon un deuxième mode de réalisation, l'alimentation du porte-substrat se présente dorénavant comme une alimentation plateau ALTj qui comporte un générateur de courant continu SCC dont le premier pôle est raccordé à la masse. Le premier pôle du condensateur CDS est raccordé au plateau porte-substrat PPS et au deuxième pôle du générateur de courant SCC tandis que son deuxième pôle est relié à la masse.

Il est souhaitable que le générateur de courant SCC soit inhibé durant l'impulsion plasma ou, autrement dit, que le condensateur CDS ne soit pas alimenté par ce générateur pendant cette impulsion. A titre d'exemple, on peut prévoir un commutateur (non représenté) qui raccorde le deuxième pôle du générateur SCC, soit au premier pôle du condensateur CDS (comme ci-dessus) en l'absence d'impulsion plasma, soit au premier pôle d'une résistance (non représentée) au cours d'une impulsion plasma, le deuxième pôle de cette résistance étant raccordé à la masse. Avantageusement, on peut utiliser le mode « inhibit » (mot anglais signifiant inhibé) qui est prévu sur la plupart des générateurs à découpage.

Là encore, lorsque le générateur de courant SCC est inhibé, la relation précédente entre la durée minimale de l'impulsion plasma tp et la valeur maximale de capacité C s'applique :

$$C / tp < - 1 / (Zp. \ln (V_{inv} / V_{ali})).$$

Les paramètres couramment utilisés dans ce mode sont :

- densité plasma comprise entre $10^8$ et $10^{10}$/cm$^3$,
- durée d'impulsion plasma comprise entre 15 μs et 500 μs,
- fréquence de répétition des impulsions comprise entre 1 Hz et 3 kHz,
- pression de travail comprise entre $2.10^{-4}$ et $5.10^{-3}$ mbar,
- gaz employé : BF$_3$, PH$_3$, AsH$_3$, N$_2$, O$_2$, H$_2$ ou Ar,
- capacité C de 500 pF,
- tension de polarisation comprise entre -100 V et - 100 kV.

Le procédé d'implantation mettant dans ce cas en oeuvre l'implanteur IMP est analogue au précédent, hormis l'absence de l'impédance de charge Z.

Dans ce cas, on utilise directement un générateur de courant, ou chargeur de condensateur, et l'on arrête la charge lorsque la tension souhaitée aux bornes du condensateur est atteinte. L'avantage de ce second mode est la suppression de l'impédance de charge Z qui est un élément de consommation de puissance et de fragilité pour la machine.

L'invention concerne donc tous les générateurs associés à une branche de dérivation. Elle consiste à limiter cette branche de dérivation à un unique condensateur.

A la demande, les pompes primaire PP et secondaire PS assurent la mise en dépression souhaitée de l'enceinte ENV après disposition d'un substrat SUB sur le plateau porte substrat PPS.

Généralement, la source plasma pulsée est une alimentation RF de fréquence 13,56 MHz ± 10%.

Le courant moyen d'implantation dépend de la densité du plasma, de la tension de polarisation, de la fréquence et de la durée des impulsions plasma. Pour des conditions instantanées fixées, le courant peut se régler par ajustement de la période de répétition des impulsions. Pour des implantations à 50 KeV, la plage de réglage du courant sera de 1 μA à 100 mA. Pour des implantations à 500 eV, de 1 μA à 10 mA.

La valeur minimale de tension du substrat dépend dune part du temps de décharge, équivalent au temps d'allumage plasma, et d'autre part de la valeur de la capacité.

La valeur maximale de tension du substrat dépend de la charge du condensateur.

Une caractéristique additionnelle de l'implanteur représentée sur la figure 1 permet d'uniformiser l'implantation pour un substrat de grande taille.

Comme évoqué précédemment, le substrat SUB repose sur un plateau porte substrat PPS généralement discoïdal et mobile autour de son axe vertical AXT. Avec ou sans rotation, si l'axe AXP de la source plasma ALP surplombant le substrat SUB est proche de l'axe AXT du plateau PPS, la diffusion plasma sera maximale le long de cet axe, et présentera un gradient de répartition par rapport à cet axe. La dose implantée dans le substrat SUB présentera une répartition non homogène.

Si les deux axes AXT, AXP présentent un désaxage, la rotation du plateau porte-substrat PPS permet de déplacer le substrat SUB par rapport à l'axe AXP de la source plasma. La dose implantée dans le substrat SUB présentera une répartition dont l'homogénéité sera sensiblement améliorée.

L'efficacité de ce système a été vérifiée sur des tranches de silicium de diamètre 200 mm pour lesquelles la non homogénéité obtenue s'est avérée inférieure à 2,5% pour une implantation de $BF_3$ à 500 eV et $10^{15}/cm^2$.

Les exemples de réalisation de l'invention présentés ci-dessus ont été choisi eu égard à leur caractère concret. Il ne serait cependant pas possible de répertorier de manière exhaustive tous les modes de réalisation que recouvre cette invention. En particulier, tout moyen décrit peut être remplacé par un moyen équivalent sans sortir du cadre de la présente invention.

**Revendications**

1. Alimentation (ALT, ALTi, ALTj) d'implanteur ionique, comprenant un générateur électrique continu (SOU, SCC) disposé entre un plateau porte-substrat (PPS) et la masse (E), comprenant aussi un condensateur (CDS) dans une branche de dérivation également disposée entre ledit plateau porte-substrat (PPS) et la masse (E), **caractérisée en ce que** ledit condensateur (CDS) a une capacité inférieure à 5 nF.

2. Alimentation selon la revendication 1, **caractérisée en ce que** ladite branche de dérivation se réduit audit condensateur (CDS).

3. Alimentation selon l'une quelconque des revendications 1 ou 2 **caractérisée en ce que**, ledit générateur étant un générateur de tension (SOU), elle comporte une impédance de charge (Z) en série avec celui-ci.

4. Alimentation selon la revendication 3, **caractérisé en ce que** ladite impédance de charge (Z) est une résistance qui est comprise entre 200 et 2 000 k$\Omega$.

5. Alimentation selon l'une quelconque des revendications 3 ou 4, **caractérisée en ce que** la tension délivrée par ledit générateur (SOU), est comprise entre - 100 et - 10 000 Volts.

6. Alimentation selon l'une quelconque des revendications 1 ou 2, **caractérisé en ce que** ledit générateur est un générateur de courant (SCC).

7. Alimentation selon la revendication 6, **caractérisée en ce que** la tension délivrée par ledit générateur (SCC) est comprise entre - 100 et - 100 000 Volts.

8. Implanteur ionique comportant une alimentation conforme à l'une quelconque des revendications 1 à 5 et une source plasma pulsée (ALP), **caractérisé en ce qu'**il comprend des moyens pour que la durée de l'impulsion plasma émise par ladite source plasma pulsée (ALP) soit comprise entre 20 $\mu$s et 5 000 $\mu$s.

9. Implanteur ionique comportant une alimentation conforme à l'une quelconque des revendications 6 ou 7 et une source plasma pulsée (ALP) **caractérisé en ce qu'**il comprend des moyens pour que la durée de l'impulsion plasma émise par ladite source plasma pulsée (ALP) soit comprise entre 20 $\mu$s et 5 000 $\mu$s et **en ce qu'**il comprend des moyens pour inhiber ledit générateur de courant (SCC) durant cette impulsion plasma.

10. Implanteur selon l'une quelconque des revendications 8 ou 9, **caractérisé en ce que** l'impédance électrique du plasma est comprise entre 30 et 300 k$\Omega$.

11. Implanteur selon l'une quelconque des revendications 8 à 10, **caractérisé en ce que** la pression de travail est inférieure à 5.10$^{-3}$ mbar.

12. Implanteur selon l'une quelconque des revendications 8 à 11, **caractérisé en ce que** la capacité C dudit condensateur (CDS) la durée tp de l'impulsion produite par ladite source plasma pulsée (ALP), la valeur Zp de l'impédance équivalente du plasma, ladite tension d'inversion $V_{inv}$ et la tension $V_{ali}$ délivrée par ledit générateurs (SOU, SCC) sont régis par la formule :

$$C / tp < -1 / (Zp. \ln (V_{inv} / V_{ali})).$$

13. Implanteur selon l'une quelconque des revendications 8 à 12, **caractérisé en ce que** ledit plateau porte-substrat (PPS) est mobile en rotation autour de son axe (AXT).

14. Implanteur selon la revendication 13, **caractérisé en ce que** ledit plateau porte-substrat (PPS) et ladite source plasma pulsée (ALP) présentent un désaxage réglable.

**Claims**

1. A power supply (ALT, ALTi, ALTj) for an ion implanter, the power supply comprising a direct current electricity generator (sou, SCC) placed between a substrate-carrier tray (PPS) and ground (E), the power supply further comprising a capacitor (CDS) in a parallel branch likewise connected between said substrate-carrier tray (PPS) and ground (E), the power supply being **characterized in that** said capacitor (CDS) has capacitance of less than 5 nF.

2. A power supply according to claim 1, **characterized in that** said parallel branch comprises said capacitor (CDS) only.

3. A power supply according to claim 1 or claim 2, **characterized in that** said generator is a voltage generator (SOU), and it includes a load impedance (Z) in series therewith.

4. A power supply according to claim 3, **characterized in that** said load impedance (Z) presents resistance lying in the range 200 k$\Omega$ to 2000 k$\Omega$.

5. A power supply according to claim 3 or claim 4, **characterized in that** the voltage delivered by said generator (SOU) lies in the range -100 V to -10,000 V.

6. A power supply according to claim 1 or claim 2, **characterized in that** said generator is a current generator (SCC).

7. A power supply according to claim 6, **characterized in that** the voltage delivered by said generator (SCC) lies in the range -100 V to -100,000 V.

8. An ion implanter comprising a power supply according to any one of claims 1 to 5 and a pulsed plasma source (ALP), and **characterized in that** it includes means for ensuring that the duration of the plasma pulse emitted by said pulsed plasma source (ALP) lies in the range 20 $\mu$s to 5000 $\mu$s.

9. An ion implanter comprising a power supply according to claim 6 or claim 7, and a pulsed plasma source (ALP), and **characterized in that** it includes means for ensuring that the duration of the plasma pulse emitted by said pulsed plasma source (ALP) lies in the range 20 $\mu$s to 5000 $\mu$s, and **in that** it includes means for inhibiting said current generator (SCC) during said plasma pulse.

10. An implanter according to claim 8 or claim 9, **characterized in that** the electrical impedance of the plasma lies in the range 30 k$\Omega$ to 300 k$\Omega$.

11. An implanter according to any one of claims 8 to 10, **characterized in that** the working pressure is less than $5 \times 10^{-3}$ mbar.

12. An implanter according to any one of claims 8 to 11, **characterized in that** the capacitance C of said capacitor (CDS), the duration tp of the pulse produced by said pulsed plasma source (ALP), the value Zp of the equivalent impedance of the plasma, said inversion voltage $V_{inv}$, and the voltage $V_{ps}$ delivered by said generator (SOU, SCC), are governed by the following formula:

$$C/tp < -1/(Zp.\ln(V_{inv}/V_{ps}))$$

**13.** An implanter according to any one of claims 8 to 12, **characterized in that** said substrate-carrier tray (PPS) is rotatable about its axis (AXT).

**14.** An implanter according to claim 13, **characterized in that** said substrate-carrier tray (PPS) and said pulsed plasma source (ALP) present an adjustable offset between their axes.

**Patentansprüche**

**1.** Versorgung (ALT, ALTi, ALTj) eines Ionenimplantators, die einen elektrischen Gleichgenerator (SOU, SCC) enthält, der zwischen einer Substratträgerplatte (PPS) und Masse (E) angeordnet ist, die auch einen Kondensator (CDS) in einem Ableitungszweig enthält, der ebenfalls zwischen der Substratträgerplatte (PPS) und Masse (E) angeordnet ist, **dadurch gekennzeichnet, dass** der Kondensator (CDS) eine Kapazität niedriger als 5 nF hat.

**2.** Versorgung nach Anspruch 1, **dadurch gekennzeichnet, dass** der Ableitungszweig auf den Kondensator (CDS) reduziert ist.

**3.** Versorgung nach einem der Ansprüche 1 oder 2, **dadurch gekennzeichnet, dass** sie, wenn der Generator ein Spannungsgenerator (SOU) ist, eine Lastimpedanz (Z) in Reihe mit diesem aufweist.

**4.** Versorgung nach Anspruch 3, **dadurch gekennzeichnet, dass** die Lastimpedanz (z) ein Widerstand ist, der zwischen 200 und 2000 kΩ liegt.

**5.** Versorgung nach einem der Ansprüche 3 oder 4, **dadurch gekennzeichnet, dass** die von dem Generator (SOU) gelieferte Spannung zwischen - 100 und - 10 000 Volt liegt.

**6.** Versorgung nach einem der Ansprüche 1 oder 2, **dadurch gekennzeichnet, dass** der Generator ein Stromgenerator ist (SCC).

**7.** Versorgung nach Anspruch 6, **dadurch gekennzeichnet, dass** die vom Generator (SCC) gelieferte Spannung zwischen - 100 und - 100 000 Volt liegt.

**8.** Ionenimplantator, der eine Versorgung nach einem der Ansprüche 1 bis 5 und eine gepulste Plasmaquelle (ALP) aufweist,
**dadurch gekennzeichnet, dass** er Einrichtungen enthält, damit die Dauer des von der gepulsten Plasmaquelle (ALP) emittierten Plasmaimpulses zwischen 20 μs und 5 000 μs liegt.

**9.** Ionenimplantator, der eine Versorgung nach einem der Ansprüche 6 oder 7 und eine gepulste Plasmaquelle (ALP) aufweist, **dadurch gekennzeichnet, dass** er Einrichtungen enthält, damit die Dauer des von der gepulsten Plasmaquelle (ALP) emittierten Plasmaimpulses zwischen 20 μs und 5 000 μs liegt, und dass er Einrichtungen enthält, um den Stromgenerator (SCC) während dieses Plasmaimpulses zu sperren.

**10.** Implantator nach einem der Ansprüche 8 oder 9, **dadurch gekennzeichnet, dass** die elektrische Impedanz des Plasmas zwischen 30 und 300 kΩ liegt.

**11.** Implantator nach einem der Ansprüche 8 bis 10, **dadurch gekennzeichnet, dass** der Arbeitsdruck unter $5.10^{-1}$ mBar liegt.

**12.** Implantator nach einem der Ansprüche 8 bis 11, **dadurch gekennzeichnet, dass** die Kapazität C des Kondensators (CDS), die Dauer tp des von der gepulsten Plasmaquelle (ALP) erzeugten Impulses, der Wert Zp der äquivalenten Impedanz des Plasmas, die Umkehrspannung $V_{inv}$ und die vom Generator (SOU, SCC) gelieferte Spannung $V_{ali}$ durch die folgende Formel geregelt werden:

$$C/tp < -1 \ / \ (Zp.In(V_{inv} \ / \ V_{ali})).$$

**13.** Implantator nach einem der Ansprüche 8 bis 12, **dadurch gekennzeichnet, dass** die Substratträgerplatte (PPS) um ihre Achse (AXT) drehbeweglich ist.

**14.** Implantator nach Anspruch 13, **dadurch gekennzeichnet, dass** die Substratträgerplatte (PPS) und die gepulste Plasmaquelle (ALP) einen einstellbaren Achsversatz haben.

$$C/tp < -1 \ / \ (Zp.In(V_{inv} \ / \ V_{ali})).$$

**Figure 1**

Z

SOU

Z

CDS

E

ALTi

**Figure 2**

SCC

CDS

E

ALTj

**Figure 3**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5558718 A

**Littérature non-brevet citée dans la description**

- Proceedings of the VIth International Workshop on Plasma-Based Ion Implantation (PBII - 2001), Grenoble, France, 25-28 June, 2001. Surface and Coatings Technology n° 156. Elsevier Science, 2001
- **S.B. FELCH et al.** *Plasma doping for the fabrication of ultra shallow junctions,* 229-236
- **D. LENOBLE et al.** *The fabrication of advanced transistors with plasma doping,* 262-266